# EUROPÄISCHE PATENTANMELDUNG

(11) **EP 0 752 593 A2**
(43) Veröffentlichungstag der Anmeldung: **08.01.1997**
(21) Anmeldenummer: 96108957.0
(22) Anmeldetag: 04.06.1996
(51) Int. Cl.: G01R 31/316, G01R 27/20

(54) **Verfahren zur Früherkennung von Ausfällen bei Leistungshalbleitermodulen**

(30) Priorität: 07.07.1995 DE 19524871
(71) Anmelder: SIEMENS AKTIENGESELLSCHAFT, 80333 München (DE)
(72) Erfinder: Farokhzad, Babak, Dipl.-Ing., 83607 Holzkirchen (DE)

(57) **Zusammenfassung**

Der Anmeldungsgegenstand betrifft ein Verfahren, bei dem durch Messung des Widerstandes (REH) zwischen einem gebondeten Emitteranschluß (E) und einem gebondeten Hilfsemitteranschluß (H) die Degradation der Bondstelle ermittelt und ein Frühwarnsignal (LED) gebildet wird, damit das Leistungshalbleitermodul bereits vor einem Ausfall ausgewechselt und damit die Gesamtzuverlässigkeit eines leistungselektronischen Systems erhöht werden kann.

## Beschreibung

Leistungshalbleitermodule, wie beispielsweise IGBT (Isolated Gate Bipolar Transistor)-Module, führen durch ihre exzellenten elektrischen Eigenschaften zu enormen Verbesserungen bei leistungselektronischen Systemen. Trotzdem kommen zum Beispiel Hochleistungs-IGBT-Module in ausfallkritischen Systemen, wie beispielsweise in U- und S-Bahnen bzw. in Aufzügen, nicht zum Einsatz, da sie die von Traktionsanwendern an sie gestellten Anforderungen bezüglich ihrer Zuverlässigkeit nicht erfüllen können. Eine wesentliche Schwachstelle derartiger Module stellen die Bondverbindungen eines Moduls dar.

Die der Erfindung zugrundeliegende Aufgabe besteht nun darin, ein Verfahren zur Früherkennung von Ausfällen anzugeben, bei dem bereits vor dem Lösen der entsprechenden Bondverbindung des Leistungshalbleitermoduls ein Warnsignal erzeugbar ist, um die Gesamtzuverlässigkeit eines leistungselektronischen Systems zu erhöhen. Diese Aufgabe wird erfindungsgemäß durch die Merkmale des Patentanspruchs 1 gelöst.

Vorteilhafte Weiterbildungen des erfindungsgemäßen Verfahrens ergeben sich aus den Unteransprüchen, wobei die Weiterbildung nach Patentanspruch 3 ein besonders zuverlässiges Erkennen von Frühausfällen ermöglicht und die Empfindlichkeit gegenüber Störspannungen hierbei besonders gering ist.

Nachfolgend wird die Erfindung anhand von Zeichnungen näher erläutert. Dabei zeigt:
- Figur 1: eine Anordnung zur Durchführung einer ersten Weiterbildung des erfindungsgemäßen Verfahrens,
- Figur 2: eine Anordnung zur Durchführung einer anderen Weiterbildung des erfindungsgemäßen Verfahrens und

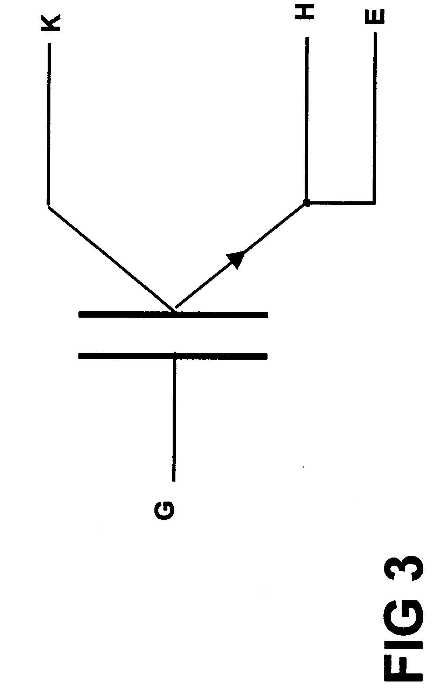

- Figur 3: ein Schaltbild eines IGBT's mit Hilfsemitter und Emitter.

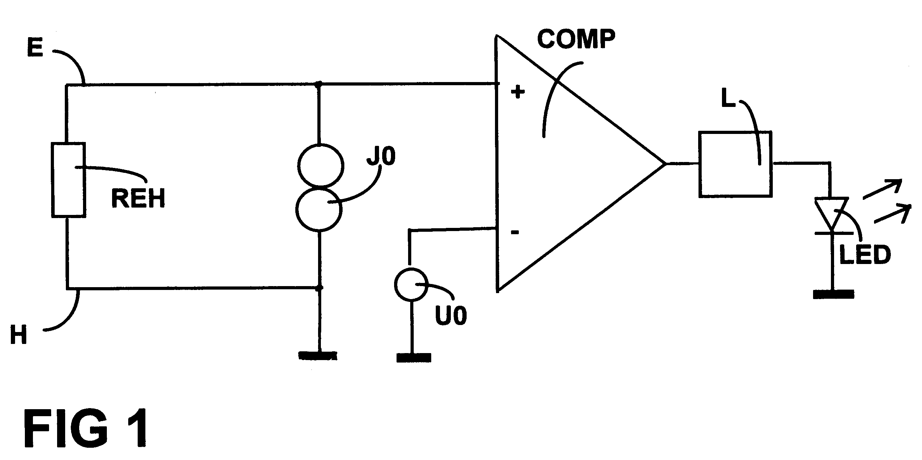

In Figur 1 ist eine Anordnung zur Durchführung einer ersten Weiterbildung des erfindungsgemäßen Verfahrens gezeigt, bei der ein Widerstand REH eine Gleichstromquelle I0, eine Referenzspannung U0, ein Komparator COMP, eine Logikeinheit L und eine Leuchtdiode LED vorgesehen sind, wobei der Widerstand REH einen gebondeten Emitteranschluß E mit einem gebondeten Hilfsemitteranschluß H verbindet. Der Abstand der beiden Anschlüsse E und H liegt dabei typischerweise in der Größenordnung von 0,1 mm.

In den Widerstand REH wird ein Konstantstrom J0 eingeprägt, der beispielsweise 100 mA beträgt. Der Spannungsabfall am Widerstand REH ist eine Funktion der Bondstellendegradation und kann, beispielsweise mit Hilfe eines Komparators COMP, mit einer Referenzspannung U0 verglichen werden. Falls der Spannungsabfall die Referenzspannung U0 überschreitet, wird beispielsweise mit Hilfe einer logischen Schaltung und einer Anzeigeeinheit, die beispielsweise aus einer Leuchtdiode LED besteht, ein Warnsignal angezeigt. Vor dem Lösen einer Bondverbindung steigt dabei der Widerstand einer Bondstelle von beispielsweise von ca. 20 mΩ auf ca. 100 bis 500 mΩ an. Dieser Widerstandsanstieg erfolgt in einem Zeitraum der ausreichend Zeit bietet, um ein entsprechendes Modul auszuwechseln.

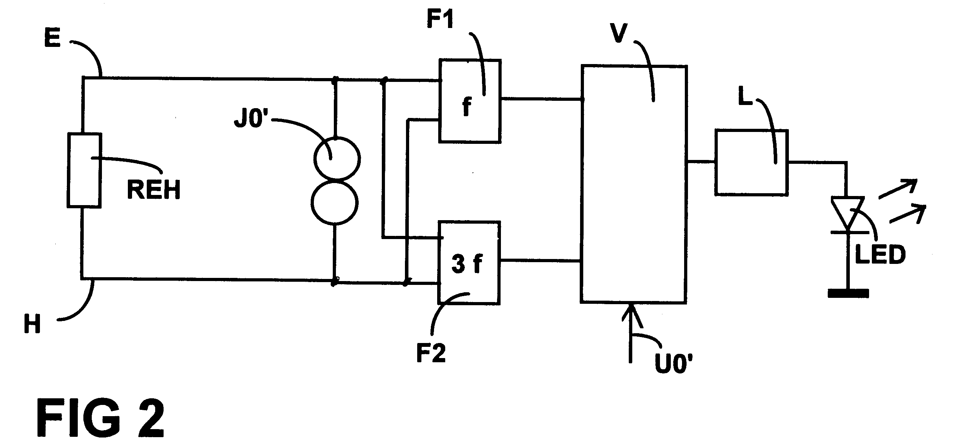

In Figur 2 ist eine Anordnung zur Durchführung einer anderen Weiterbildung des erfindungsgemäßen Verfahrens dargestellt, bei der anstelle der Gleichstromquelle J0 eine Wechselstromquelle J0' mit einer konstanten Grundfrequenz f und einer konstanten Amplitude, und anstelle der Referenzspannung U0 und des Komparators COMP eine erste Filterschaltung F1 zur Ausfilterung der Grundwelle mit der Frequenz f, eine zweite Filterschaltung F2 zur Ausfilterung der dritten Oberwelle mit der Frequenz 3f und eine Verarbeitungseinheit V vorgesehen sind, wobei der Verarbeitungseinheit V eine Referenzspannung U0' zugeführt wird.

In den Widerstand REH wird hierbei ein sinusförmiger Strom, dessen Amplitude beispielsweise 0,7 A und dessen Frequenz beispielsweise 1 kHz beträgt, eingeprägt und aus dem am Widerstand REH liegenden Spannungsabfall mit Hilfe eines ersten Filters F1 eine Grundwelle der Frequenz f und mit Hilfe eines zweiten Filters F2 die dritte Harmonische mit der Frequenz 3f ausgefiltert. Die Grundwelle und die dritte Harmonische bilden dabei Meßgrößen für die jeweilige Bondstellendegradation und können beispielsweise in einer Verarbeitungseinheit V mit dem Referenzspannungswert U0' verglichen werden, wobei die die Verarbeitungseinheit V beispielsweise aus einer Einheit zur gewichteten Summenbildung besteht, die zum Beispiel aus einem Operationsverstärker besteht, der mit zwei Eingangswiderständen und einem Rückkoppelwiderstand beschaltet ist. Für die Gewichtungsfaktoren der Grundwelle und der dritten Oberwelle sind auch jeweils die Werte Null und eine entsprechend vereinfachte Schaltung denkbar.

Alternativ können die Filter F1 und F2 beispielsweise durch einen Digitalen Signal Prozessor mit FFT (Fast Fourier Transform) und/oder die Verarbeitungseinheit V zum Beispiel durch ein Neuronales Netz, einen Fuzzy Controller oder eine Neuro-Fuzzy Einheit ersetzt sein.

Falls die Ausgangsspannung der Verarbeitungseinheit den Referenzspannungswert überschreitet, wird, wie bei der ersten Weiterbildung der Erfindung, mit Hilfe einer logischen Schaltung L und einer Anzeigeeinheit LED ein Frühwarnsignal erzeugt bzw. angezeigt. Versuche haben dabei gezeigt, daß beim Übergang von einem intakten zu einem geschädigten Bauelement zum Beispiel die Amplitude der Grundwelle ca. auf das 1,5 fache und die der dritten Harmonischen auf das ca. 12 fache ansteigen.

Ein besonderer Vorteil der Erfindung liegt darin, daß die Messung nicht durch die Eigenschaften des Halbleiterchips beeinflußt bzw. gestört wird.

## Patentansprüche

1. Verfahren zur Früherkennung von Ausfallen bei Leistungshalbleitermodulen mit gebondeten Emitteranschlüssen (E, H), bei dem der Wert und/oder die Linearität eines ohmschen Widerstandes (REH) zwischen einem Emitteranschluß (E) und einem Hilfsemitteranschluß (H) ermittelt wird, wobei über den Hilfsemitteranschluß nur ein Meßstrom (I0, I0') fließt, und bei dem ein Warnsignal (LED) erzeugt wird, sobald der Wert und/oder die Linearität des ohmschen Widerstandes einen kritischen Wert überschreitet.

2. Verfahren nach Anspruch 1,
bei dem in den ohmschen Widerstand (REH) ein konstanter Gleichstrom (I0) eingeprägt wird und der Spannungsabfall über den ohmschen Widerstand in einem Komparator (COMP) mit einer Referenzspannung (U0) für einen kritischen Widerstandswert verglichen wird.

3. Verfahren nach Anspruch 1,
bei dem in den ohmschen Widerstand (REH) ein sinusförmiger Wechselstrom (I0') mit einer konstanten Frequenz (f) und einer konstanten Amplitude eingeprägt wird und aus dem Spannungsabfall am ohmschen Widerstand durch einen ersten Filter (F1) eine Grundwelle der konstanten Frequenz (f) und/oder durch ein zweites Filter (F2) eine dritte Oberwelle (3f) ausgefiltert werden und bei dem in einer Verarbeitungseinheit (V) aus der Grundwelle und/oder der dritten Oberwelle ein Bewertungssignal gebildet und mit einer Referenzspannung (U0') für den kritischen Wert verglichen wird.

4. Verfahren nach Anspruch 3,
bei dem das Bewertungssignal aus der Grundwelle und der dritten Oberwelle durch gewichtete Summenbildung gebildet wird.

5. Verfahren nach einem der Ansprüche 2 bis 4,
bei dem mit Hilfe einer Logikeinheit (L) und einer optischen Anzeige (LED) ein bevorstehender Ausfall angezeigt wird, sobald der kritische Wert überschritten wird.

6. Verfahren nach einem der vorhergehenden Ansprüche,
bei dem die Leistungshalbleitermodule IGBT-Module sind.
